# EUROPÄISCHE PATENTSCHRIFT

(11) **EP 1 622 826 B1**
(45) Veröffentlichungstag und Bekanntmachung des Hinweises auf die Patenterteilung: **13.06.2007**
(21) Anmeldenummer: 04727838.7
(22) Anmeldetag: 16.04.2004
(51) Int. Cl.: B81C 1/00, H01L 21/3205, C30B 33/12

(54) **MIKROMECHANISCHE UHRWERKBAUTEILE UND VERFAHREN ZU IHRER HERSTELLUNG**
MICROMECHANICAL CLOCKWORK COMPONENTS AND METHOD FOR THEIR PRODUCTION
COMPOSANTS MICROMECANIQUES D'HORLOGERIE ET SES PROCEDES DE PRODUCTION

(30) Priorität: 17.04.2003 DE 10317889
(43) Veröffentlichungstag der Anmeldung: 08.02.2006
(73) Patentinhaber: GFD Gesellschaft für Diamantprodukte mbH, 89081 Ulm (DE)
(72) Erfinder: FLÖTER, André, 89567 Sontheim/Brenz (DE); GLUCHE, Peter, 89073 Ulm (DE); ERTL, Stephan, 77710 Haslach i.K. (DE); GEIGER, Dietmar, 89075 Ulm (DE)
(74) Vertreter: Pfenning, Meinig & Partner GbR
(86) Internationale Anmeldenummer: PCT/EP2004/004075
(87) Internationale Veröffentlichungsnummer: WO 2004/092049

(56) Entgegenhaltungen:
- EP-A- 0 732 635
- EP-A- 1 271 155
- WO-A-99/37437
- DE-A- 19 808 326
- FLEISCHMAN A J ET AL: "POLYCRYSTALLINE SILICON CARBIDE FOR SURFACE MICROMACHINING" PROCEEDINGS OF THE 9TH. ANNUAL INTERNATIONAL WORKSHOP ON MICRO ELECTROMECHANICAL SYSTEMS. INVESTIGATION OF MICRO STRUCTURES, SENSORS, ACTUATORS, MACHINES AND SYSTEMS. SAN DIEGO, FEB. 11 - 15, 1996, PROCEEDINGS OF THE ANNUAL INTERNATIONAL WORKSHOP ON, Bd. WORKSHOP 9, 11. Februar 1996 (1996-02-11), Seiten 234-238, XP000689281 ISBN: 0-7803-2986-4
- HUNN J D ET AL: "FABRICATION OF SINGLE-CRYSTAL DIAMOND MICROCOMPONENTS" APPLIED PHYSICS LETTERS, AMERICAN INSTITUTE OF PHYSICS. NEW YORK, US, Bd. 65, Nr. 24, 12. Dezember 1994 (1994-12-12), Seiten 3072-3074, XP000485931 ISSN: 0003-6951

## Beschreibung

Die vorliegende Erfindung betrifft mikromechanische Uhrwerkbauteile sowie ein Verfahren zu ihrer Herstellung. Derartige mikromechanische Bauteile sind insbesondere Zahnräder, Unruhe, Feder und/oder Zeiger.

Nach dem Stand der Technik sind mikromechanische Bauteile gewöhnlich aus Metallen oder anderen Festkörpern hergestellt. Es wurden bereits mikromechanische Bauteile aus Diamant mit Abmessungen, wie sie beispielsweise für den Einsatz in einer Uhr benötigt werden, gefertigt, (www. iaf-fraunhofer.de und dortige Verweise). Jedoch ist es bisher nicht gelungen, diese Teile so herzustellen, dass sie geeignet sind, in einem mikromechanischen Getriebe, z. B. in einem Uhrlaufwerk, eingesetzt zu werden. Bisherige, aus Diamant gefertigte mikromechanische Bauteile werden dabei so hergestellt, dass zuerst über ein CVD-Verfahren Diamant auf einem flachen bzw. scheibenförmigen Substrat abgeschieden wird. Dies kann bis zu einer Stärke von etwa 3 mm erfolgen. Um aus einer derartigen einheitlichen Diamantschicht das gewünschte mikromechanische Bauteil zu erhalten, wird mittels eines gütegeschalteten Nd:YAG-Lasers die gewünschte Form aus der Diamantscheibe herausgeschnitten. Aufgrund der sehr hohen Wärmeleitfähigkeit von Diamant ist ein thermisches Schneidverfahren in der Anwendung problematisch. Ein ähnliches Herstellungsverfahren wurde in J.D. Hunn et al., Appl. Phys. Lett., Vol. 65, Seiten 3072-3074 (XP 485931) veröffentlicht.

Die so hergestellten mikromechanischen Bauteile haben daher den Nachteil, dass die bearbeitete Schnittfläche als Oberfläche überaus rauh ist und insbesondere aufgrund der thermischen Wirkung des Lasers nicht senkrecht auf der flächig ausgedehnten Scheibenoberfläche steht. Die Oberflächen sind daher für mikromechanische Bauteile ungenügend. Lediglich die Scheibenoberfläche kann durch Schleifen und Polieren auf Rauhigkeitswerte unter 20 Å gebracht werden. Feinere Strukturen können mit Lasern nicht erzeugt werden aufgrund der begrenzten Fokussierbarkeit von Lasern. Es sind lediglich minimale Schnittbreiten von ca. 50 µm möglich.

Die vorliegende Erfindung stellt sich daher die Aufgabe, ein mikromechanisches Uhrwerkbauteil zur Verfügung zu stellen, bei dem eine erste und eine zweite Oberfläche im Wesentlichen senkrecht aufeinander stehen. Weitere Aufgabe der vorliegenden Erfindung ist es, ein Verfahren anzugeben, mit dem derartige Bauteile hergestellt werden können.

Diese Aufgabe wird durch das mikromechanische Uhrwerkbauteil nach Anspruch 1 und das Verfahren nach Anspruch 10 gelöst. Vorteilhafte Weiterbildungen des erfindungsgemäßen mikromechanischen Uhrwerkbauteils und des erfindungsgemäßen Verfahrens wird in den jeweiligen abhängigen Ansprüchen gegeben.

Erfindungsgemäß besteht das mikromechanische Bauteil aus Diamant. Erfindungsgemäß wird erstmals ein mikromechanisches Uhrwerkbauteil zur Verfügung gestellt, dessen Oberflächen senkrecht aufeinander stehen. Hierzu wird zuerst eine aus den obigen Materialien bestehende Schicht auf einem Substrat abgeschieden und anschließend das Bauteil in seiner Außenkontur mittels eines Ätzschrittes und einer Ätzmaske auf einer ersten Oberfläche der abgeschiedenen ersten Schicht herausgeätzt. Durch die Auswahl geeigneter Prozessparameter und/oder Prozessgase gelingt es, die Selektivität der Ätzraten zwischen Maskenmaterial und der zu ätzenden Schicht sicherzustellen. Dadurch ist es möglich, eine im Wesentlichen rechtwinklige Kante zwischen der Oberfläche der ersten abgeschiedenen Schicht und der Ätzkante auszubilden. Besonders vorteilhaft wird reaktives Ionenätzen verwendet, beispielsweise mittels Chlor oder Sauerstoff.

Ein ähnliches Ätzverfahren mit dem Ziel eine schräge Schneidkante einer Diamantschneide zu erzeugen, ist in der WO 99/37437 offenbart, deren Offenbarung bezüglich des Ätzverfahrens hiermit vollständig in die vorliegende Anmeldung aufgenommen wird.

Mit dem erfindungsgemäßen Verfahren ist es also erstmals möglich, ein mikromechanisches Uhrwerkbauteil zu schaffen, bei dem eine erste und eine zweite Oberfläche im wesentlichen senkrecht aufeinander stehen, vorteilhafterweise mit einer Abweichung um weniger als 2° von der Senkrechten. Es ist auch erstmals möglich, ein Bauteil zu schaffen, dessen zweite Oberfläche aus Diamant eine mittlere Rauhigkeit Rᵣₘₛ < 2 µm (rms = root mean square, Wurzel des arithmetischen Mittels) aufweist.

Aufgrund der glatten Kanten und Flächen ist insbesondere die Abnutzung des Gleit- bzw. Reibpartners, beispielsweise eines metallischen zweiten Zahnrades sehr gering. Vorteilhafterweise können zur weiteren Verringerung der Reibung und der Abnutzung die Kanten zwischen den beiden Oberflächen verrundet werden. Dies ist beispielsweise in einem Ultraschallbad möglich, dessen Badflüssigkeit Diamantpartikel und/oder eine sauerstoffhaltige Substanz (Sauerstoff als Atom, in einem Molekül oder als Radikal), z.B. Kaliumpermanganat oder Kaliumnitrat, enthält.

Da das Bauteil aus Diamant gefertigt ist, hat es überragende mechanische und chemische Eigenschaften. Zu erwähnen sind hier insbesondere seine hohe Wärmeleitfähigkeit, die ein Überhitzen des Bauteils verhindert, sein hohes E-Modul, die geringe Wärmeausdehnung, die den Einsatz des Bauteils unter wechselnden Temperaturen mit dennoch geringen Toleranzen ermöglicht, seine hohe Verschleißfestigkeit, und sein geringer Reibungskoeffizient. All diese Eigenschaften ermöglichen es, Mikrobauteile mit bisher nicht erreichten Gebrauchseigenschaften herzustellen.

Im Folgenden werden einige Beispiele erfindungsgemäßer Herstellungsverfahren beschrieben.

Es zeigen:
- Fig. 1: ein Schema eines mikromechanischen Bauteils;
- Fig. 2: ein Herstellungsverfahren für ein mikromechanisches Bauelement;
- Fig. 3: ein weiteres Herstellungsverfahren für ein mikromechanisches Bauteil;
- Fig. 4: ein mikromechanisches Bauteil; und
- Fig. 5: Vorrichtungen zum Herstellen erfindungsgemäßer mikromechanischer Bauteile.

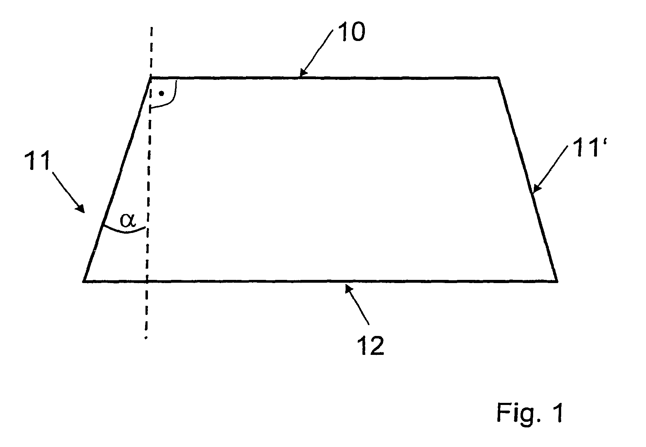

Fig. 1 zeigt schematisch ein erfindungsgemäßes mikromechanisches Bauteil mit zwei parallelen Oberflächen 10, 12 als erste Oberflächen und Flanken 11, 11' als zweite Oberflächen. Die Oberflächen 10, 12 und Flanken 11, 11' stehen im Wesentlichen senkrecht zu einander. Die Vertikalität der Flanken 11, 11' weicht dabei höchstens zu einem Winkel α < 10°, vorzugsweise α < 5°, vorzugsweise α < 2° von der orthogonalen Orientierung ab.

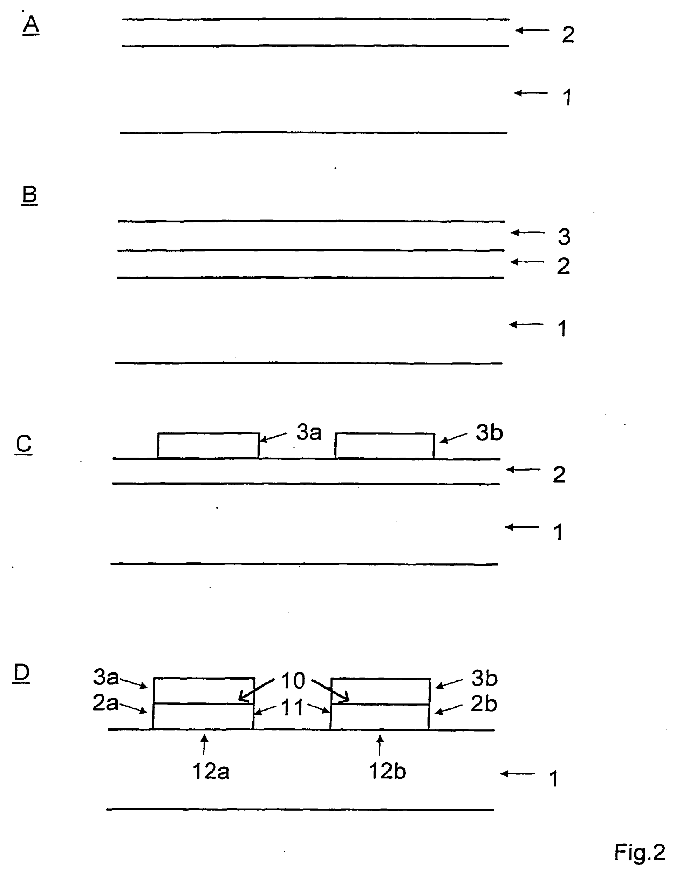

Fig.2 zeigt ein Herstellungsverfahren in den Teilbildern A bis D, bei dem (Teilbild A) zuerst auf einer Substratschicht 1 aus Silizium oder Polysilizium eine Schicht 2 aus Diamant über ein CVD- oder PVD-Verfahren abgeschieden wird. Anschließend wird die Diamantschicht 2 mit einer weiteren Siliziumschicht 3 beschichtet (Fig. 2B), die anschließend strukturiert wird, um eine Ätzmaske 3a, 3b zu bilden (Fig. 2C). Anschließend findet ein Ätzschritt statt, dessen Verfahrensparameter so gewählt werden, dass die Diamantschicht 2 in den Bereichen abgeätzt wird, in denen sie nicht von der Maske 3a, 3b bedeckt ist. Dabei bilden sich seitliche Flanken 11 aus, die bei geeigneter Wahl der Verfahrensbedingungen im Wesentlichen senkrecht auf der Grenzschicht zwischen den verbleibenden Diamantelementen 2a, 2b und der Ätzmaske 3a und 3b steht. Anschließend werden sowohl die Ätzmaske 3a, 3b als auch die Substratschicht 1 als Opferschicht entfernt, so dass die Elemente 2a und 2b als mikromechanische Bauteile übrig bleiben. Die Flanken 11, die beim Ätzen entstanden sind, stehen dabei im Wesentlichen senkrecht auf den gegenüberliegenden Oberflächen 10, 12a und 12b.

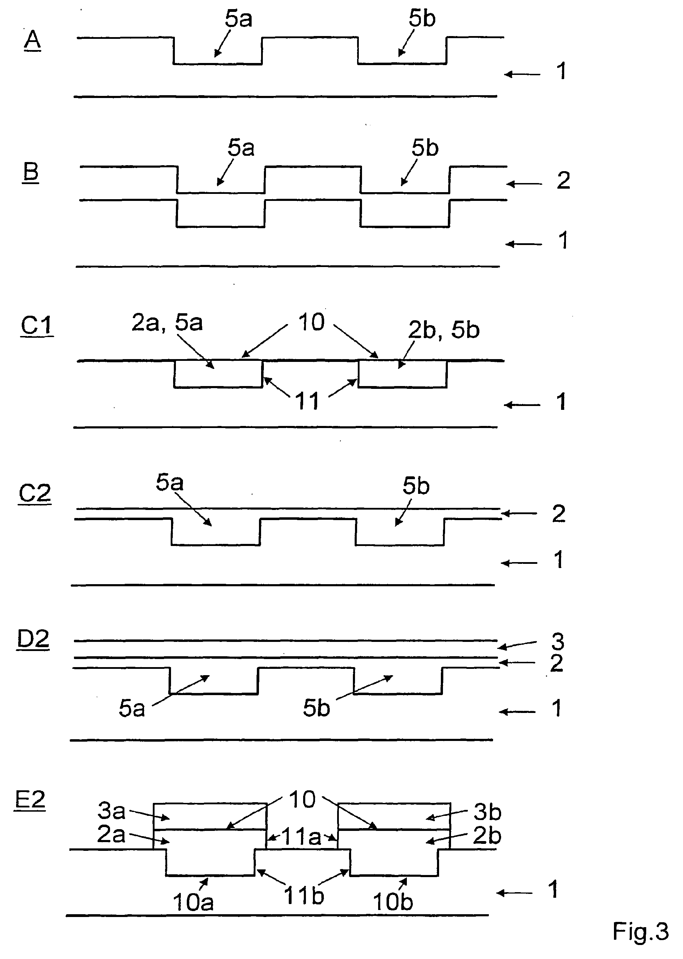

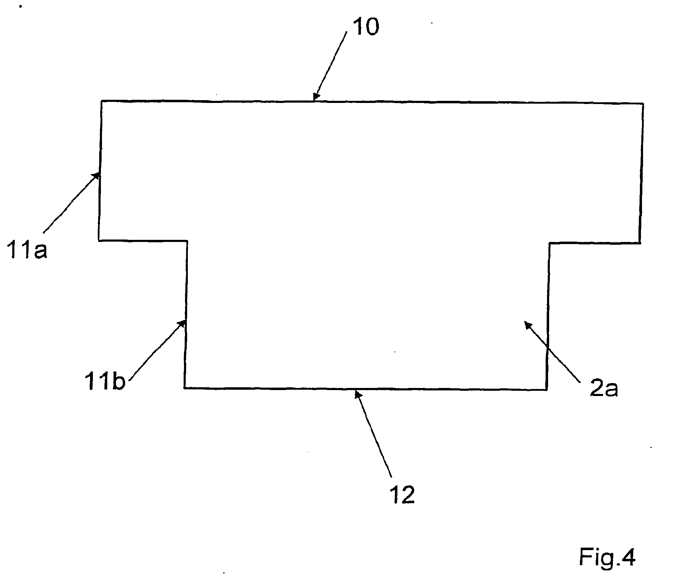

Fig. 3 zeigt ein weiteres Herstellungsverfahren für ein Zahnrad (falls der Fertigungsprozess nach Schritt C1 abgebrochen wird) bzw. ein Doppelzahnrad, wie es in Fig. 4 dargestellt ist. Dieses Doppelzahnrad besitzt zwei Zahnoberflächen 11a, 11b, die jeweils senkrecht zu den benachbarten Oberflächen 10, 12 sind. Die Zahnflächen 11a und 11b entsprechen verschiedenen Zahnradradien.

Wie in Fig. 3A zu erkennen ist, wird zuerst eine strukturierte Substratschicht 1 aus Silizium, Polysilizium oder einem Carbid eines Metalls der 3ten bis 5ten Hauptgruppe des Periodensystems hergestellt, die Vertiefungen 5a und 5b aufweist. Auf diese Substratschicht 1 wird nun eine Diamantschicht 2 abgeschieden, wobei deren Dicke so gewählt wird, dass die Vertiefung 5a und 5b sich nunmehr auch in der Diamantschicht 2 ausprägen.

In einem Schritt C1 wird nun die Diamantschicht 2 bis auf die ursprüngliche Oberfläche der Substratschicht 1 abgeschliffen, so dass die Diamantschicht in zwei Bereiche 2a und 2b zerfällt, die in den Vertiefungen 5a bzw. 5b angeordnet sind. An ihrer Oberfläche bilden sie Oberflächen 10 aus, während senkrecht hierzu in den Vertiefungen 5a, 5b vertikale Flanken 11 als Grenzfläche zwischen der Diamantschicht 2a, 2b und der Substratschicht 1 vorliegen.

Alternativ zum Schritt C1 ist es auch möglich, in einem Schritt C2 die Diamantschicht nicht vollständig bis zur Oberfläche der Substratschicht abzuschleifen, so dass eine durchgehende Diamantschicht stehen bleibt.

Fig. 3D2 zeigt nun einen weiteren Schritt ausgehend von Fig. 3C2, wobei hier jetzt die Diamantschicht 2 mit einer weiteren Siliziumschicht 3 als Ätzmaske überschichtet wird. Diese Ätzmaske 3 wird strukturiert, so dass sie wie in Fig. 3E2 zu sehen ist, zwei Maskenelemente 3a und 3b bilden, die einen größeren Durchmesser als die Vertiefungen 5a und 5b besitzen. Anschließend erfolgt ein Ätzschritt, dessen Verfahrensbedingungen so gewählt werden, dass die sich senkrecht ausbildenden Oberflächen 11a der Diamantelemente 2a, 2b im wesentlichen senkrecht auf den Grenzflächen 10 zwischen den Diamantelementen 2a, 2b und der Ätzmasken 3a und 3b stehen.

Abschließend wird sowohl das Substrat 1 als Opferschicht als auch die Ätzmasken 3a, 3b entfernt, so dass das mikromechanische Bauteil, das in Fig. 4 gezeigt ist, erhalten wird.

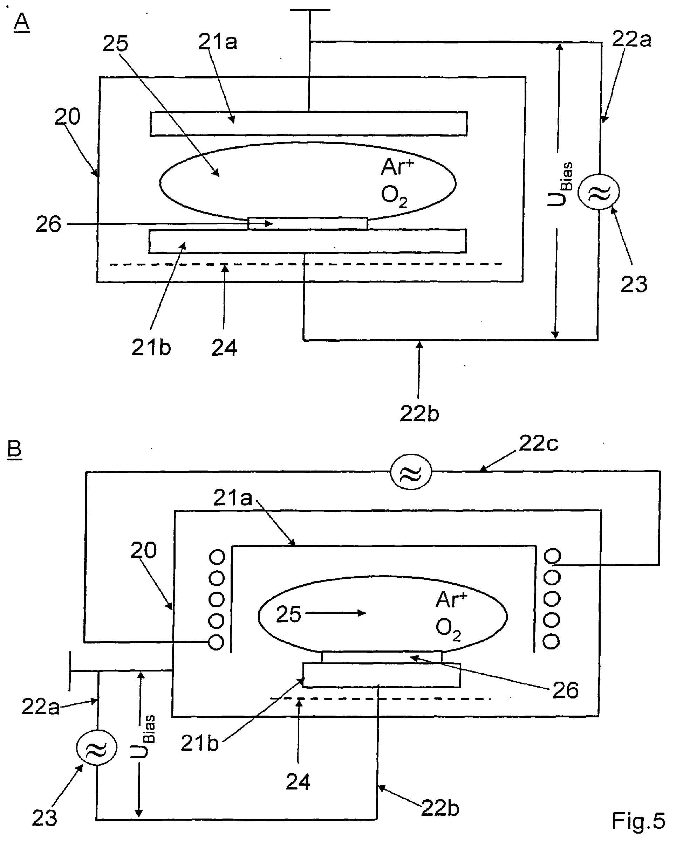

Fig. 5 zeigt nun verschiedene Anlagen, die zur Herstellung der erfindungsgemäßen mikromechanischen Bauteile verwendet werden können.

Fig. 5A zeigt eine RIE-Anlage (Reactive Ion Etching) mit rein kapazitivem Betrieb. Diese Anlage weist eine Kammer 20 auf, in der ein Substrat 26 auf einer Unterlage 21b angeordnet ist. Dem Substrat 26 gegenüber ist eine Elektrode 21a angeordnet. Die Elektrode 21a und die Unterlage 21b sind über Leitungen 22a und 22b mit einer Spannungsquelle 23 verbunden, die eine Leistung zwischen 1 W und 3000 W erzeugt. Hierdurch wird ein Plasma 25 aus Argon-Ionen und Sauerstoff zwischen dem Substrat 26 und der Elektrode 21a erzeugt, das das Substrat in den nicht von einer Maske bedeckten Bereichen ätzt. Dabei ergibt sich eine Self-Bias-Spannung mit negativem Potential. Der Self-Bias-Spannung kann eine zusätzliche, erzwungene Spannung überlagert werden. Dies geschieht durch Einfügen eines Gleichstromgenerators zwischen Substratelektrode und Erdung.

Fig. 5B zeigt eine weitere Anlage nach dem ICP-Verfahren (Inductive Coupled Plasma). Hier wie zuvor auch sind gleiche oder ähnliche Bauelemente mit gleichen oder ähnlichen Bezugszeichen wie in den anderen Figuren versehen. Statt der Elektrode 21a ist nun innerhalb der Kammer 20 eine Elektrode 21a mit einer Spule angeordnet, über die induktiv die Leistung in das Plasma 25 eingekoppelt wird. Die Kammer 20 und die Unterlage 21b sind ebenfalls über eine Spannungsquelle 23 miteinander verbunden.

In beiden Anlagen beträgt die Self-Bias-Spannung vorteilhafterweise 20 bis 1.000 V, vorzugsweise 250 bis 800 V, vorzugsweise zwischen 350 und 700 V.

Wesentliche Parameter bei der Verfahrensführung für den Ätzschritt sind der Kammerdruck und die Partialdruckverhältnisse.

Insbesondere der Kammerdruck ist für die hohe Vertikalität des Ätzprozesses und den anisotropen Ätzangriff von wesentlicher Bedeutung. Ziel ist dabei ein niedriger Kammerdruck bei gleichzeitig ausreichender Menge von reaktiven Spezies. Als geeignete Druckwerte für die RIE-Anlage wurden Werte < 150 mTorr, vorzugsweise < 75 mTorr, vorzugsweise < 35 mTorr ermittelt. Für die ICP-Anlage beträgt der Kammerdruck vorzugsweise 0,1 bis 20 mTorr.

Die genannten Bereiche des Kammerdrucks führen zu einer anisotropen Ätzung, während sich bei hohem Druck zu viele Atome in der Kammer befinden, die die Argon-ionen während des Beschusses ablenken. Bei zu hohem Kammerdruck wird daher eine isotrope Ätzung bewirkt.

Über die Partialdruckverhältnisse kann insbesondere die Ätzgeschwindigkeit und damit auch die Anisotropie der Ätzung beeinflusst werden. Vorzugsweise beträgt das Partialdruckverhältnis zwischen den Partialdrücken von Ar+ und O₂ zwischen 0,0 und 10,0, vorzugsweise zwischen 0,2 und 2,0, vorzugsweise zwischen 0,4 und 0,6. Auf den in Fig. 5 gezeigten Anlagen ergeben sich im oben genannten Parameterbereich Ätzgeschwindigkeiten zwischen 100 nm/Stunde und 10 µm/Stunde.

Statt Argon und Sauerstoff als Plasma-Gase können auch andere Systeme eingesetzt werden. Insbesondere kommen statt Argon alle Edelgase der zweiten Hauptgruppe des Periodensystems der Elemente in Frage. Anstelle von Sauerstoff als reaktivem Gas kommen alle Gase in Frage, die mit Kohlenstoff eine flüchtige Verbindung eingehen können, insbesondere
1. chlorhaltige Gase, z. B. Cl₂, CCl₂, BCl₃, PCl₃ sowie weitere chlorhaltige Gase und/oder deren Mischungen;
2. fluorhaltige Gase, z. B. F, F₂, CF₄, CFₙ, C₂F₆, SF₄, SF₆, SF₄ sowie weitere fluorhaltige Gase sowie deren Verbindungen und/oder Mischungen;
3. sauerstoffhaltige Gase O₂, CO, CO₂ sowie weitere sauerstoffhaltige Gase und/oder deren Mischungen;
4. Gase, die Fluor und/oder Chlor und/oder Sauerstoff enthalten, z. B. CClF₂, CClF₅, CClF₃ und/oder deren Mischungen.

Während des Ätzprozesses ist es weiterhin wichtig, Redepositionen, zu denen es während des Ätzprozesses kommt, in regelmäßigen oder unregelmäßigen Abständen zu entfernen, um glatte Oberflächen an der senkrechten zweiten Fläche 11 zu erzielen. Denn bei dem laufenden Prozess zur Diamantätzung kommt es durch den Ionen-Beschuss zu Redepositionen des Maskenmaterials und sonstiger Partikel auf der zu ätzenden Schicht. Daher wird der Ätzprozess nach einiger Zeit, z. B. nach 20 min unterbrochen. Es folgt dann ein kurzer Ätzschritt von ca. einer Minute, z. B. Standard-Siliziumätzschritt, um Silizium-Redepositionen zu entfernen. Hierzu wird als Gas beispielsweise CF₄ bei 75 mTorr Partialdruck verwendet. Zusätzlich sollte die Probe chemisch gereinigt werden und zwar nach etwa 50 µm Ätztiefe. Hierzu bietet sich die RCA-Reinigung, wie sie in der Siliziumbearbeitung Standard ist, an.

## Patentansprüche

1. Mikromechanische Uhrwerksbauteile mit einer ersten Oberfläche und einer hierzu als Flanke ausgebildeten zweiten Oberfläche, die aufeinander im wesentlichen senkrecht stehen, wobei die erste und/oder die zweite Oberfläche zumindest bereichsweise aus Diamant (Cᵢ) bestehen und die die Flanke bildende zweite Oberfläche eine mittlere Rauhigkeit ≤ 2 µm aufweist.

2. Uhrwerkbauteile nach Anspruch 1, **dadurch gekennzeichnet, dass** die zweite Oberfläche eine mittlere Rauhigkeit Rᵣₘₛ ≤ 500 nm aufweist.

3. Uhrwerkbauteile nach einem der vorhergehenden Ansprüche, **dadurch gekennzeichnet, dass** der Winkel zwischen der ersten und der zweiten Oberfläche um weniger als 5° von der Senkrechten abweicht.

4. Uhrwerkbauteile nach einem der vorhergehenden Ansprüche, **dadurch gekennzeichnet, dass** der Winkel zwischen der ersten und der zweiten Oberfläche um weniger als 2° von der Senkrechten abweicht.

5. Uhrwerkbauteile nach einem der vorhergehenden Ansprüche, **dadurch gekennzeichnet, dass** seine Dicke senkrecht zur ersten Oberfläche zwischen 0,5 µm und 3000 µm beträgt.

6. Uhrwerkbauteile nach einem der vorhergehenden Ansprüche, **dadurch gekennzeichnet, dass** seine Stärke in Richtung der zweiten Oberfläche zwischen 10 µm und 500 µm beträgt.

7. Uhrwerkbauteile nach einem der vorhergehenden Ansprüche, **dadurch gekennzeichnet, dass** seine Stärke in Richtung der zweiten Oberfläche zwischen 30 µm und 200 µm beträgt.

8. Uhrwerkbauteile nach einem der vorhergehenden Ansprüche, **dadurch gekennzeichnet, dass** das Bauteil in seinem Innern, seine erste und/oder zweite Oberfläche aus Diamant besteht und zumindest bereichsweise elektrisch leitend dotiert ist.

9. Uhrwerkbauteile nach einem der vorhergehenden Ansprüche, **dadurch gekennzeichnet, dass** es ein Zahnrad, Unruhe, Feder, Ziffernblatt, Lagerstein, Wellen, Grundplatte, Blocker, Hemmung und/oder Zeiger ist.

10. Verfahren zur Herstellung eines mikromechanischen Uhrwerkbauteils nach einem der vorhergehenden Ansprüche mit den folgenden Schritten:
a) Abscheiden einer ersten Schicht aus Diamant (Cᵢ) auf einem Substratmaterial,
b) Strukturieren einer Kante zwischen der ersten und der die Flanke bildenden zweiten Oberfläche durch mindestens einen Ätzschritt unter Verwendung einer Ätzmaske auf der ersten Oberfläche, welche getrennt von der ersten Schicht oder gleichzeitig mit der ersten Schicht geätzt wird, wobei
das Verhältnis der Ätzgeschwindigkeiten von erster Schicht und Ätzmaske derart eingestellt wird, dass zwischen der ersten und der zweiten Oberfläche eine im Wesentlichen rechtwinklige Kante ausgebildet wird.

11. Verfahren nach dem vorhergehenden Anspruch, **dadurch gekennzeichnet, dass** der Ätzschritt trockenchemisch unter Zuhilfenahme eines Plasmas durchgeführt wird.

12. Verwendung nach Anspruch 10, **dadurch gekennzeichnet, dass** der Ätzschritt eine reaktive und/oder physikalische Komponente enthält.

13. Verfahren nach Anspruch 10, **dadurch gekennzeichnet, dass** bei dem Ätzschritt reaktives Ionenätzen verwendet wird.

14. Verfahren nach einem der Ansprüche 10 bis 13, **dadurch gekennzeichnet, dass** die Ätzmaske und die erste Schicht in ein oder mehreren Ätzschritten gemeinsam oder getrennt voneinander geätzt werden.

15. Verfahren nach einem der Ansprüche 10 bis 14, **dadurch gekennzeichnet, dass** vor dem Durchführen des mindestens einen Ätzschrittes zur Strukturierung des Bauteils umfassenden Verfahrens eine Strukturierung des Substratmaterials durchgeführt wird und das strukturierte Substratmaterial als Ätzmaske verwendet wird.

16. Verfahren nach einem der Ansprüche 10 bis 15, **dadurch gekennzeichnet, dass** mit Sauerstoff, Fluor und/oder Chlor als reaktiver Komponente geätzt wird.

17. Verfahren nach einem der Ansprüche 10 bis 15, **dadurch gekennzeichnet, dass** mit einem Edelgas der Gruppe 8 des Periodensystems als physikalische Komponente geätzt wird.

18. Verfahren nach einem der Ansprüche 10 bis 17, **dadurch gekennzeichnet, dass** während des Ätzschrittes eine Biasspannung an dem Substrat anliegt bzw. angelegt wird.

19. Verfahren nach dem vorhergehenden Anspruch, **dadurch gekennzeichnet, dass** eine Biasspannung von 10-1000 Volt an dem Substrat anliegt bzw. angelegt wird.

20. Verfahren nach dem vorhergehenden Anspruch, **dadurch gekennzeichnet, dass** eine Biasspannung von 250-800 Volt an dem Substrat anliegt bzw. angelegt wird.

21. Verfahren nach dem vorhergehenden Anspruch, **dadurch gekennzeichnet, dass** eine Biasspannung von 350-700 Volt an dem Substrat anliegt bzw. angelegt wird.

22. Verfahren nach den Ansprüchen 10 bis 21, **dadurch gekennzeichnet, dass** der Ätzschritt ein- oder mehrmals in unterschiedlichen oder periodischen Abständen unterbrochen wird.

23. Verfahren nach dem vorhergehenden Anspruch, **dadurch gekennzeichnet, dass** während der Unterbrechung des Ätzschrittes eine Reinigung der Substratoberfläche, beispielsweise von Redepositionen, durchgeführt wird.

## Claims

1. Micro-mechanical clockwork components with a first surface and a second surface forming a flank for the first, the same being positioned substantially vertical in relation to each other, whereby the first and/or the second surface consists at least in part of diamond (Cᵢ), and the second surface forming the flank has a roughness of ≤ 2 µm.

2. Clockwork components according to Claim 1, **characterised in that** the second surface has a median roughness Rᵣₘₛ of ≤ 500 nm.

3. Clockwork components according to one of the preceding Claims, **characterised in that** the angle between the first and the second surface deviates from the vertical by less than 5°.

4. Clockwork components according to one of the preceding Claims, **characterised in that** the angle between the first and the second surface deviates from the vertical by less than 2°.

5. Clockwork components according to one of the preceding Claims, **characterised in that** the thickness of the same vertical to the first surface is between 0.5 µm and 3000 µm.

6. Clockwork components according to one of the preceding Claims, **characterised in that** the thickness of the same in direction of the second surface is between 10 µm and 500 µm.

7. Clockwork components according to one of the preceding Claims, **characterised in that** the thickness of the same in the direction of the second surface is between 30 µm and 200 µm.

8. Clockwork components according to one of the preceding Claims, **characterised in that** the component in the interior of the same, its first and/or second surface consists of diamond and is doted at least in some areas to be electrically conductive.

9. Clockwork components according to one of the preceding Claims, **characterised in that** the same comprise of a gear wheel, a movement, a spring, a clock face, a bearing stone, shafts, a base plate, blocker, inhibitor and/or a hand.

10. Method for producing a micro-mechanical clockwork component according to one of the preceding Claims with the following steps:
a) Separating of a first layer made of diamond (Cᵢ) onto a substrate material;
b) Structuring an edge between the first and the second surface forming the flank by means of at least one etching step using an etching matrix on the first surface, the same being etched separately from the first layer, or simultaneously with the first layer, whereby the ratio of the etching speed of the first layer in relation to the etching matrix is adjusted in such a way that a substantially right angled edge is formed between the first and the second surface.

11. Method according to one of the preceding Claims, **characterised in that** the etching step is carried out by means of a dry mixture whilst utilising a plasma.

12. Method according to Claim 10, **characterised in that** the etching step comprises a reactive and/or physical component.

13. Method according to Claim 10, **characterised in that** reactive ion etching is used during the etching step.

14. Method according to one of the Claims 10 to 13, **characterised in that** the etching matrix and the first step are etched during one or more etching steps either together or separately from each other.

15. Method according to one of the Claims 10 to 14, **characterised in that** prior to carrying out the method comprising at least one etching step for structuring the component a structuring of the substrate material is carried out, and the structured substrate material is used as an etching matrix.

16. Method according to one of the Claims 10 to 15, **characterised in that** the same is carried out with oxygen, fluoride and/or chlorine as the reactive component.

17. Method according to one of the Claims 10 to 15, **characterised in that** a rare gas of group 8 of the period system is used as the physical component.

18. Method according to one of the Claims 10 to 17, **characterised in that** a bias voltage is applied, e.g. supplied to the substrate during the etching step.

19. Method according to one of the preceding Claims, **characterised in that** a bias voltage of 10-1000 volt is applied, e.g. supplied to the substrate.

20. Method according to one of the preceding Claims, **characterised in that** a bias voltage of 250-800 volt is applied, e.g. supplied to the substrate.

21. Method according to one of the preceding Claims, **characterised in that** a bias voltage of 350-700 volt is applied, e.g. supplied to the substrate.

22. Method according to Claims 10 to 21, **characterised in that** the etching step is interrupted at periodical intervals once or several times.

23. Method according to the preceding Claim, **characterised in that** a cleaning of the substrate surface, for example of redepositionings, is carried out during the interruption of the etching step.

## Revendications

1. Composant micromécanique d'horlogerie avec une première surface et une seconde surface formant un flanc relativement à la première surface, lesdites surfaces se situant substantiellement perpendiculairement l'une à l'autre, dans lequel la première et/ou la seconde surface sont constituées au moins localement de diamant (Cᵢ) et la seconde surface formant le flanc présente une rugosité moyenne arithmétique ≤ 2 µm.

2. Composant d'horlogerie selon la revendication 1, **caractérisé en ce que** la seconde surface présente une rugosité moyenne arithmétique Rᵣₘₛ ≤ 500 nm.

3. Composant d'horlogerie selon l'une des revendications précédentes, **caractérisé en ce que** l'angle entre la première et la seconde surface diverge de moins de 5° par rapport à la verticale.

4. Composant d'horlogerie selon l'une des revendications précédentes, **caractérisé en ce que** l'angle entre la première et la seconde surface diverge de moins de 2° par rapport à la verticale.

5. Composant d'horlogerie selon l'une des revendications précédentes, **caractérisé en ce que** son épaisseur perpendiculairement à la première surface est comprise entre 0,5 µm et 3000 µm.

6. Composant d'horlogerie selon l'une des revendications précédentes, **caractérisé en ce que** son étendue en direction de la seconde surface est comprise entre 10 µm et 500 µm.

7. Composant d'horlogerie selon l'une des revendications précédentes, **caractérisé en ce que** son étendue en direction de la seconde surface est comprise entre 30 µm et 200 µm.

8. Composant d'horlogerie selon l'une des revendications précédentes, **caractérisé en ce que** le composant est constitué de diamant dans sa partie interne, sur sa première surface et/ou sur sa seconde surface, et **en ce qu'**il est rendu électriquement conducteur au moins localement.

9. Composant d'horlogerie selon l'une des revendications précédentes, **caractérisé en ce qu'**il s'agit d'une roue dentée, d'un balancier, d'un ressort, d'un cadran, d'un rubis, d'une tige, d'une plaque de montage, d'un condensateur d'arrêt, d'un échappement et/ou d'une aiguille.

10. Procédé de fabrication d'un composant micromécanique d'horlogerie selon une des revendications précédentes comprenant les étapes suivantes :
a) séparation d'une première couche de diamant (Cᵢ) sur un matériau de substrat,
b) structuration d'une arête entre la première surface et la seconde surface formant le flanc par au moins une étape de gravure en utilisant un masque de gravure sur la première surface, qui est attaquée séparément de la première couche ou simultanément à la première couche,
dans lequel
le rapport des vitesses de gravure de la première couche et du masque de gravure est ajusté de telle sorte qu'une arête essentiellement rectangulaire est formée entre les première et seconde surfaces.

11. Procédé selon la revendication précédente, **caractérisé en ce que** l'étape de gravure est réalisée chimiquement par voie sèche à l'aide d'un plasma.

12. Utilisation selon la revendication 10, **caractérisée en ce que** l'étape de gravure contient un composant réactif et/ou physique.

13. Procédé selon la revendication 10, **caractérisé en ce que** la gravure ionique réactive est utilisée pendant l'étape de gravure.

14. Procédé selon une des revendications 10 à 13, **caractérisé en ce que** le masque de gravure et la première couche sont gravés ensemble en une ou plusieurs étapes de gravure ou séparément l'un de l'autre.

15. Procédé selon une des revendications 10 à 14, **caractérisé en ce que**, avant la réalisation d'un procédé comprenant au moins une étape de gravure en vue de la structuration du composant, une structuration du matériau de substrat est réalisée et le matériau de substrat structuré est utilisé en tant que masque de gravure.

16. Procédé selon une des revendications 10 à 15, **caractérisé en ce que** la gravure est effectuée avec de l'oxygène, du fluor et/ou du chlore en tant que composants réactifs.

17. Procédé selon une des revendications 10 à 15, **caractérisé en ce que** la gravure est effectuée avec un gaz rare du groupe VIII du système périodique en tant que composants physiques.

18. Procédé selon une des revendications 10 à 17, **caractérisé en ce qu'**une tension de polarisation s'applique et/ou est appliquée au substrat pendant l'étape de gravure.

19. Procédé selon la revendication précédente, **caractérisé en ce qu'**une tension de polarisation de 10-1000 Volt s'applique et/ou est appliquée au substrat.

20. Procédé selon la revendication précédente, **caractérisé en ce qu'**une tension de polarisation de 250-800 Volt s'applique et/ou est appliquée au substrat.

21. Procédé selon la revendication précédente, **caractérisé en ce qu'**une tension de polarisation de 350-700 Volt s'applique et/ou est appliquée au substrat.

22. Procédé selon les revendications 10 à 21, **caractérisé en ce que** l'étape de gravure est interrompue une ou plusieurs fois à différents intervalles ou à des intervalles périodiques.

23. Procédé selon la revendication précédente, **caractérisé en ce qu'**un nettoyage de la surface de substrat, par exemple des dépôts réitérés, est réalisé pendant l'interruption de l'étape de gravure.
